Europäisches Patentamt

European Patent Office

Office européen des brevets

(19)

(11) Veröffentlichungsnummer: **0 271 166 B1**

(12) **EUROPÄISCHE PATENTSCHRIFT**

(45) Veröffentlichungstag der Patentschrift: **23.03.94**

(21) Anmeldenummer: **87202447.6**

(22) Anmeldetag: **08.12.87**

(51) Int. Cl.⁵: **H03M  1/08**, H03M 7/30, H03M 3/02

(54) **Digitale Schaltungsanordnung zur Verringerung des Ouantisierungsrauschens.**

(30) Priorität: **10.12.86 DE 3642168**

(43) Veröffentlichungstag der Anmeldung:
**15.06.88 Patentblatt  88/24**

(45) Bekanntmachung des Hinweises auf die
Patenterteilung:
**23.03.94 Patentblatt  94/12**

(84) Benannte Vertragsstaaten:
**AT BE DE FR GB IT NL**

(56) Entgegenhaltungen:
**EP-A- 0 180 461**
**EP-A- 0 241 077**
**US-A- 4 109 110**
**US-A- 4 306 222**
**US-A- 4 692 737**

(73) Patentinhaber: **Philips Patentverwaltung
GmbH
Wendenstrasse 35c
D-20097 Hamburg(DE)**

(84) Benannte Vertragsstaaten:
**DE**

(73) Patentinhaber: **N.V. Philips' Gloeilampenfabrieken
Groenewoudseweg 1
NL-5621 BA Eindhoven(NL)**

(84) Benannte Vertragsstaaten:
**BE FR GB IT NL AT**

(72) Erfinder: **Bradinal, Werner
Lutterothstrasse 57
D-2000 Hamburg 20(DE)**

(74) Vertreter: **Hartmann, Heinrich, Dipl.-Ing. et al
Philips Patentverwaltung GmbH,
Wendenstrasse 35c
D-20097 Hamburg (DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf eine digitale Schaltungsanordnung mit einem Interpolationsfilter zum Überabtasten eines digitalen Eingangssignals, das als Folge amplitudendiskreter Abtastwerte mit einer bestimmten Abtastfrequenz vorliegt, mit einem Störgeräuschformer, der eine Überlagerungsstufe enthält, deren Ausgang mit einem Quantisierer, deren erster Eingang mit dem Interpolationsfilter und deren zweiter Eingang mit einer in einer Rückkopplungsschleife vorgesehenen Filteranordnung zweiter Ordnung zum Filtern eines Quantisierungsfehlersignals des Quantisierers gekoppelt ist, und mit einem mit einem Ausgang des Quantisierers gekoppelten Digital-Analog-Umsetzer.

Eine solche digitale Schaltungsanordnung ist aus der DE-PS 30 21 012 bekannt. Hierbei werden die Abtastwerte des digitalen Eingangssignals mit einer bestimmten Abtastfrequenz einem Interpolationsfilter, das durch ein Register realisiert ist, zugeführt. Der Ausgang des Registers ist mit einem Störgeräuschformer ("Noise Shaper") verbunden, der einen Quantisierer, zwei Überlagerungsstufen und ein Filter enthält. Das Ausgangssignal des Filters wird in der ersten Überlagerungsstufe von dem Ausgangssignal des Registers subtrahiert. Das Ausgangssignal der ersten Überlagerungsstufe wird dem Quantisierer zugeführt, der ein linearer Quantisierer ist. Bei einem linearen Quantisierer sind die Quantisierungssprünge und die Abstände zwischen den einzelnen Quantisierungssprüngen dem Betrage nach gleich. In der zweiten Überlagerungsstufe wird das Quantisierungsfehlersignal zwischen den Ausgangssignalen des Quantisierers und der ersten Überlagerungsstufe gebildet, welches der Filteranordnung zugeführt wird. Die Abtastwerte des Quantisierungsfehlersignals werden mit einer höheren Abtastfrequenz in die Filteranordnung eingeschrieben als die Abtastwerte des Eingangssignals in das Register. Dem Störgeräuschformer ist ein Digital-Analog-Umsetzer nachgeschaltet, dessen analoges Ausgangssignal einem Tiefpaßfilter zugeführt wird, welches die periodischen Spektren des Nutzsignals unterdrückt und eine zeitliche Mittelung durchführt.

Am Ausgang des Interpolationsfilters, das in der DE-PS 30 21 012 verwendet wird, steht der zuletzt eingelesene Abtastwert zur Verfügung, der im nachgeschalteten Störgeräuschformer mit einer höheren Frequenz weiterverarbeitet wird. Hierdurch wird mit diesem Interpolationsfilter eine Überabtastung realisiert.

Aus der Zeitschrift "Elektronik", Nr. 14 vom 15.07.1983, Seiten 61 bis 64 ist eine digitale Schaltungsanordnung bekannt, die ein Interpolationsfilter verwendet, das die Abtastwerte des Eingangssignals mit einer Abtastfrequenz von 44,1 kHz einschreibt und mit einer Abtastfrequenz von 176,4 kHz ausliest. Dieses Interpolationsfilter führt sowohl eine Überabtastung um den Faktor 4 als auch eine Tiefpaßfilterung zur Unterdrückung der periodischen Spektren des Nutzsignals durch. Dem Interpolationsfilter ist ein Störgeräuschformer nachgeschaltet, dessen Ausgangssignal einem Digital-Analog-Umsetzer zugeleitet wird. Der Störgeräuschformer enthält ein Filter erster Ordnung.

Das bei der Digital-Analog-Umsetzung des quantisierten Digitalsignals entstehende Analogsignal enthält ein durch die Quantisierung hervorgerufenes Quantisierungsrauschen. Das dem Interpolationsfilter und den Störgeräuschformer zugeführte digitale Signal wird in diesen beiden Schaltungen durch Reduktion der Wortbreite weiter quantisiert, wodurch ein zusätzliches Quantisierungsrauschen entsteht. Dieses zusätzliche Quantisierungsrauschen, welches im Störgeräuschformer entsteht, ist gegenüber einem Quantisierungsrauschen, das in einer üblichen Quantisierungsschaltung ohne Überabtastung durch Quantisierung gebildet wird, geringer. Durch die Wahl des Filters wird dabei die Größe der Quantisierungsrauschverminderung bestimmt. Die Leistung des Quantisierungsrauschens wird aus dem Nutzsignalfrequenzbereich zum Teil in einen höheren Frequenzbereich gelegt. Die Größe der Absenkung des Quantisierungsrauschens im Nutzfrequenzbereich ist dabei abhängig von der Ordnung des Filters. Das Filter soll dabei ein optimales Filter bestimmter Ordnung sein, für das das Leistungsdichtespektrum des Quantisierungsrauschens minimal wird. Andererseits nimmt der Realisierungsaufwand mit der Ordnung des Filters jedoch zu. Ein guter Kompromiß zwischen dem Realisierungsaufwand und der Größe der Verminderung des Quantisierungsrauschens ergibt sich bei einem Filter zweiter Ordnung.

Mit Störgeräuschformern zweiter Ordnung hat sich in praktischen Versuchen gezeigt, daß bei hohen Werten des Betrages des Eingangssignals eine Instabilität der digitalen Schaltungsanordnung auftritt, wodurch die gewünschte Störgeräuschformung verhindert wird.

Aus der US-PS 4 306 222 ist ein D/A-Umsetzer mit einer in einer Rückkopplungsschleife vorgesehenen Filteranordnung bekannt, dessen Quantisierer ein Begrenzer vorgeschaltet ist.

In der älteren europäischen, nicht vorveröffentlichten Anmeldung EP-A-241 077, die einen Stand der Technik entsprechend Artikel 54 (3) EPÜ für die benannten Vertragsstaaten BE, DE, FR, GB, IT und NL darstellt, wird ein Koder mit einem Quantisierer und einem in einer Rückkopplungsschleife vorgesehenen Filter dritter Ordnung vorgeschlagen. Es ist ein Begrenzer vorgesehen, der das dem Filtereingang zugeführte Quantisierungsfehlersignal begrenzt.

Der Erfindung liegt die Aufgabe zugrunde, eine digitale Schaltungsanordnung der eingangs genannten Art so auszubilden, daß keine Instabilität auftritt.

Die Aufgabe wird erfindungsgemäß dadurch gelöst, daß ein Begrenzer in die Rückkopplungsschleife geschaltet ist.

In die digitale Schaltungsanordnung wird erfindungsgemäß ein Begrenzer in die Rückkopplungsschleife geschaltet, wodurch die Schaltung auch bei Werten des Betrages des Eingangssignals stabil bleibt, die nahe der unteren bzw. oberen Quantisierungsmaximalwerte liegen. Die Begrenzung setzt dabei erst ein, wenn die Summe aus dem Betrag des Ausgangssignals der Überlagerungsstufe und der Hälfte des Betrages eines Quantisierungssprunges größer als der maximale Betrag des Ausgangssignals des Quantisierers ist. Der Betrag eines Quantisierungssprunges ist der Abstand zwischen zwei möglichen Ausgangswerten des Quantisierers. Diese Begrenzung setzt dabei nicht unbedingt genau dann ein, wenn die Summe soeben größer ist als der maximale Betrag des Ausgangssignals des Quantisierers. Der obere bzw. untere Begrenzerschwellwert muß so bestimmt werden, daß bei hohen Eingangssignalen keine Instabilität auftritt, d.h. die genauen Begrenzerschwellwerte müssen durch eine praktische Untersuchung bestimmt werden.

Die Filteranordnung kann im Störgeräuschformer einerseits so geschaltet sein, daß zuerst die Differenz zwischen den Ausgangssignalen der Überlagerungsstufe und des Quantisierers gebildet wird und dann das Quantisierungsfehlersignal der Filteranordnung zugeführt wird, und andererseits das zuerst in der Filteranordnung das Ausgangssignal der Überlagerungsstufe und das Ausgangssignal des Quantisierers gefiltert werden und dann zwischen den gefilterten Ausgangssignalen der Überlagerungsstufe und des Quantisierers die Differenz gebildet wird.

Der Begrenzer kann zwischen den Ausgang der Überlagerungsstufe und den Quantisierer geschaltet sein. Ebenso besteht die Möglichkeit, daß der Begrenzer direkt hinter die Überlagerungsstufe geschaltet ist. Diese beiden Möglichkeiten sind jedoch nicht beansprucht. Des weiteren gibt es die Möglichkeit, den Begrenzer direkt vor den zweiten Eingang der Überlagerungsstufe zu schalten. Eine vierte Möglichkeit besteht darin, daß der Begrenzer vor die Filteranordnung geschaltet ist und dem Begrenzer das Quantisierungsfehlersignal zugeführt wird. Die Bildung des Quantisierungsfehlersignals kann auch durch einen Zuordner (PROM) erfolgen, der einem Wert des Ausgangssignals der Überlagerungsstufe einen bestimmten Wert des Quantisierungsfehlersignals zuordnet.

Wird die erfindungsgemäße digitale Schaltungsanordnung so weitergebildet, daß der Begrenzer vor die Filteranordnung geschaltet ist, ist vorgesehen, daß die Anordnung einen Subtrahierer zum Erzeugen des Quantisierungsfehlersignals enthält, dessen erster Eingang mit dem Ausgang der Überlagerungsstufe, dessen zweiter Eingang mit dem Ausgang des Quantisierers und dessen Ausgang mit einem Eingang des Begrenzers gekoppelt ist, dessen Ausgang mit einem Eingang der Filteranordnung gekoppelt ist, deren Ausgang mit dem zweiten Eingang der Überlagerungsstufe gekoppelt ist.

In einer Fortbildung der Erfindung ist vorgesehen, daß die Filteranordnung ein erstes Register enthält, dessen Eingang mit dem Begrenzer und dessen Ausgang mit einem Verstärker und mit einem zweiten Register gekoppelt ist und daß die Filteranordnung einen weiteren Subtrahierer enthält, dessen erster Eingang mit dem zweiten Register, dessen zweiter Eingang mit dem Verstärker und dessen Ausgang mit dem Ausgang der Filteranordnung gekoppelt ist. Die Filteranordnung 2. Ordnung weist z.B. die folgende Übertragungsfunktion auf:

$$H(z) = 2 z^{-1} - z^{-2}.$$

Bei dieser Filteranordnung wird das Leistungsdichtespektrum des Quantisierungsrauschens im Nutzsignalfrequenzbereich minimal.

Um den Digital-Analog-Umsetzer sehr einfach zu gestalten, ist vorgesehen, daß der Quantisierer ein 1 Bit-Signal erzeugt, das einen ersten Zustand annimmt, wenn das Ausgangssignal der Überlagerungsstufe positiv ist, und das einen zweiten Zustand annimmt, wenn das Ausgangssignal der Überlagerungsstufe negativ ist. Nach der Digital-Analog-Umsetzung wird das Analogsignal einem Integrator zur zeitlichen Mittelung zugeführt. Die Überabtastung muß bei Erzeugung eines 1 Bit-Ausgangssignals des Quantisierers größer sein als bei einem Mehr-Bit-Ausgangssignals des Quantisierers, damit sich derselbe Anteil des Leistungsdichtespektrums des Quantisierungsrauschens im Nutzfrequenzbereich ergibt.

Bei dieser letzgenannten Ausführungsform kann das Ausgangssignal des Quantisierers zwei Werte annehmen. Das Ausgangssignal des Interpolationsfilters kann entsprechend seiner Auflösung verschiedene Werte zwischen diesen beiden möglichen Quantisierungswerten haben. In praktischen Untersuchungen hat sich gezeigt, daß die Begrenzung nicht einsetzen darf, bevor der Betrag der Differenz zwischen dem Ausgangswert des Interpolationsfilters und dem Ausgangswert des Quantisierers kleiner als die Hälfte des Betrages eines Ausganswertes des Quantisierers ist.

Ausführungsbeispiele der Erfindung werden nachstehend anhand der Zeichnung näher erläutert. Es zeigen:

Fig. 1 ein erstes Ausführungsbeispiel der digitalen Schaltungsanordnung,

Fig. 2 Übertragungscharakteristiken verschiedener Schaltungskomponenten der Fig. 1,

Fig. 3 ein vereinfachtes Ausführungsbeispiel des in Fig. 2 verwendeten Störgeräuschformers und

Fig. 4 Übertragungscharakteristiken verschiedener Schaltungskomponenten der Fig. 3.

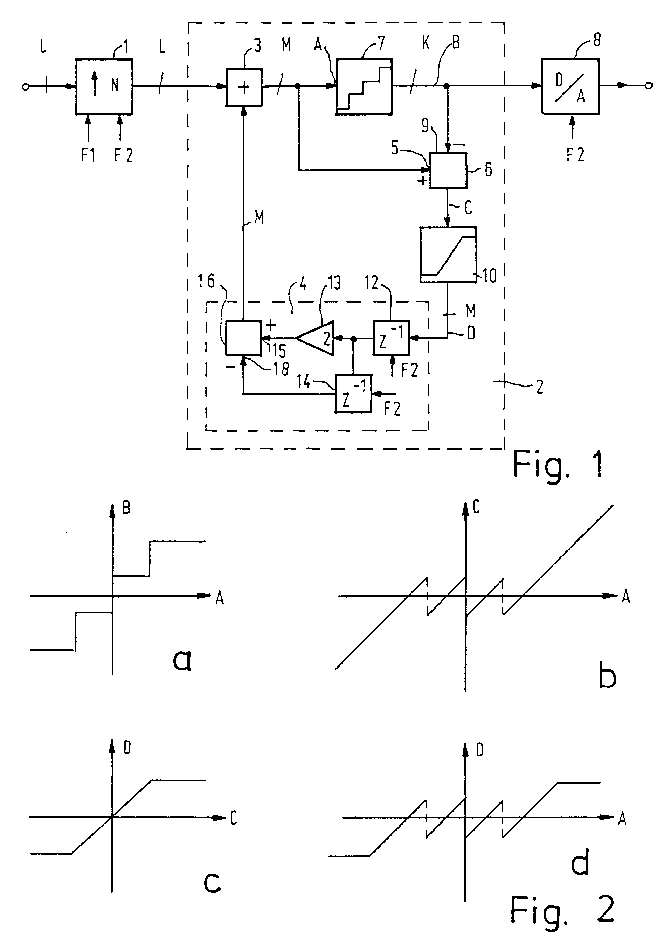

In Fig. 1 wird einem Interpolationsfilter 1 ein digitales Eingangssignal, das als Folge amplitudendiskreter Abtastwerte mit einer durch ein Taktsignal bestimmten Abtastfrequenz F1 vorliegt, zugeführt. Das Interpolationsfilter führt eine Überabtastung des digitalen Eingangssignals vor, d.h. das digitale Ausgangssignal des Interpolationsfilters 1 weist eine Folge amplitudendiskreter Abtastwerte auf, die mit einer Abtastfrequenz F2 auftreten, die das N-fache der Abtastfrequenz F1 = F2/N des Eingangssignals beträgt. Die bei der Überabtastung entstehenden zusätzlichen Abtastwerte werden durch Interpolation im Interpolationsfilter 1 gebildet. Die Wortbreite des Eingangs- bzw. Ausgangssignals des Interpolationsfilters 1 beträgt L Bit.

Das Ausgangssignal des Interpolationsfilters 1 wird einem Störgeräuschformer 2 ("Noise Shaper") zugeleitet. Eine im Störgeräuschformer 2 enthaltene Überlagerungsstufe 3 addiert das Ausgangssignal des Interpolationsfilters 1 mit dem Ausgangssignal einer Filteranordnung 4 zweiter Ordnung. Die Wortbreite des digitalen Ausgangssignals der Filteranordnung 4 beträgt M Bit, wobei M > L ist. Somit ergibt sich ein Ausgangssignal A der Überlagerungsstufe 3 mit einer Wortbreite von M Bit. Dieses Ausgangssignal A der Überlagerungsstufe 3 wird einerseits einem ersten Eingang 5 eines Subtrahierers 6 und andererseits einem linearen Quantisierer 7 zugeleitet. Der Quantisierer 7 erzeugt ein Ausgangssignal B mit einer Wortbreite von K Bit, wobei K < M ist. Ein linearer Quantisierer ist dadurch definiert, daß seine Quantisierungssprünge, das ist der Betrag zwischen zwei aufeinanderfolgenden Werten des digitalen Ausgangssignals B, und die Abstände zwischen den einzelnen Quantisierungssprüngen gleich sind. In Fig. 2a ist die Übertragungscharakteristik eines linearen Quantisierers dargestellt, der ein Ausgangssignal B mit einer Wortbreite von 2 Bit erzeugt.

Das Ausgangssignal B des Quantisierers 7 bildet das Ausgangssignal des Störgeräuschformers 2 und wird einem Digital-Analog-Umsetzer 8 zugeführt. Des weiteren wird das Ausgangssignal B des Quantisierers 7 dem zweiten Eingang 9 des Subtrahierers 6 zugeleitet. Der Subtrahierer 6 bildet ein Ausgangssignal C, in dem das Ausgangssignal B des Quantisierers 7 vom Ausgangssignal A der Überlagerungsstufe 3 subtrahiert wird. Das Ausgangssignal B des Quantisierers 7 wird mit dem Ausgangssignal A der Überlagerungsstufe 3 im Subtrahierer 6 so verknüpft, daß der maximale bzw. minimale Wert des Ausgangssignals B größer oder gleich bzw. kleiner oder gleich dem maximalen bzw. minimalen Wert des Ausgangssignals des Interpolationsfilters 1 ist. Das digitale Ausgangssignal C (Quantisierungsfehlersignal) des Subtrahierers 6 weist eine Wortbreite von M Bit auf. In Fig. 2b ist die Übertragungscharakteristik, die die Abhängigkeit des Ausgangssignals C des Subtrahierers 6 von dem Ausgangssignal A der Überlagerungsstufe 3 wiedergibt, dargestellt.

Das Ausgangssignal C des Subtrahierers 6 wird einem Begrenzer 10, der ebenfalls im Störgeräuschformer 2 enthalten ist, zugeführt. Die Übertragungscharakteristik, die die Abhängigkeit des Ausgangssignals D von dem Eingangssignal C des Begrenzers 10 wiedergibt, ist in Fig. 2c gezeigt. In Fig. 2d ist die Übertragungscharakteristik dargestellt, die die Abhängigkeit des Ausgangssignals D des Begrenzers 10 vom Ausgangssignal A der Überlagerungsstufe 3 darstellt.

Der Ausgang des Begrenzers 10 ist mit einem in der Filteranordnung 4 enthaltenen Register 12 verbunden. Der Ausgang des Registers 12 ist an einen Verstärker 13 und an ein weiteres Register 14 angeschlossen. Der Ausgang des Verstärkers 13, der einen Verstärkungsfaktor von 2 aufweist, ist mit einem ersten Eingang 15 eines Subtrahierers 16 verbunden. Außerdem ist der Ausgang des Registers 14 mit dem zweiten Eingang 18 des Subtrahierers 16 gekoppelt. Das Ausgangssignal des Subtrahierers 16, das auch das Ausgangssignal der Filteranordnung 4 darstellt, wird durch Subtraktion des Ausgangssignals des Registers 14 vom Ausgangssignal des Verstärkers 13 gebildet. Die beiden Register 12 und 14 und der Digital-Analog-Umsetzer 8 erhalten jeweils ein Taktsignal mit einer Frequenz F2.

Die Digitalisierung analoger Signale bewirkt, daß nicht der jeweilige Augenblickswert, sondern ein diskreter Amplitudenwert eines Signals übertragen wird, der sich vom Analogwert um maximal eine halbe Quantisierungsstufe unterscheiden kann. Dieser prinzipiell nicht unterdrückbare Fehler äußert sich als Störgeräusch und wird als Quantisierungsrauschen bezeichnet. Mit der in Fig. 1 dargestellten Schaltungsanordnung wird das bei der Wortbreitenreduktion im Störgeräuschformer entstehende weitere Quantisierungsrauschen verringert. Durch die Überabtastung des Interpolationsfilters 1 wird erreicht, daß das Leistungsdichtespektrum des weiteren Quantisierungsrauschens um das Verhältnis F2/F1 = N im interessierenden Frequenzbereich verringert wird. Das Leistungsdichtespektrum dieses Quantisierungsrauschens ist über den gesamten interessierenden Frequenzbereich gleichmäßig verteilt, da die aufeinanderfolgenden Fehler zwischen Eingangswert und quantisiertem Ausgangswert unkorreliert sind, d.h. das Quantisierungsrauschen ist weißes Rauschen.

Im Störgeräuschformer 2 wird das weitere Quantisierungsrauschen im interessierenden Frequenzbereich noch weiter verringert, indem das Leistungsdichtespektrum umverteilt wird, d.h. das Leistungsdichtespektrum im niedrigen Frequenzbereich wird verringert und im höheren Frequenzbereich vergrößert. Der Quantisierungsfehler des Ausgangssignals B des Quantisierers 7 wird nämlich im Subtrahierer 6 berechnet. Dieser Quantisierungsfehler wird über den Begrenzer 10 und die Filteranordnung 4 als Korrekturwert dem Eingangssignal des Störgeräuschformers 2 überlagert. Durch geeignete Wahl des Filters nimmt das Leistungsdichtespektrum bei niedrigen Frequenzen ab und bei höheren zu.

Es hat sich bei der praktischen Realisierung einer solchen digitalen Schaltungsanordnung gemäß der Fig. 1 gezeigt, daß ohne den Begrenzer 10 eine Instabilität bei hohen Eingangssignalen des Störgeräuschformers 2 auftreten kann, d.h. die erwünschte Störgeräuschformung wird verhindert. Die untere bzw. obere Begrenzerschwelle muß so gewählt werden, daß keine Instabilität auftreten kann. Die Begrenzung darf erst einsetzen, wenn die Summe aus dem Betrag des Ausgangssignals der Überlagerungsstufe und der Hälfte des Betrages eines Quantisierungssprunges größer als der maximale Betrag des Ausgangssignals des Quantisierers 7 ist. Der genaue Einsatzpunkt des Begrenzers 10 hängt auch vom Filter 4 ab. Die Begrenzerschwellen lassen sich also nur in einer praktischen digitalen Schaltung exakt bestimmen.

Die Filteranordnung 4 ist ein Transversalfilter zweiter Ordnung, das so aufgebaut ist, daß das Leistungsdichtespektrum des Quantisierungsrauschens im Nutzfrequenzbereich minimal werden kann.

Der Vorteil einer solchen Schaltungsanordnung mit einer Überabtastung und anschließender Störgeräuschformung liegt darin, daß ein Digital-Analog-Umsetzer mit geringerer Anzahl von Bits verwendet werden kann.

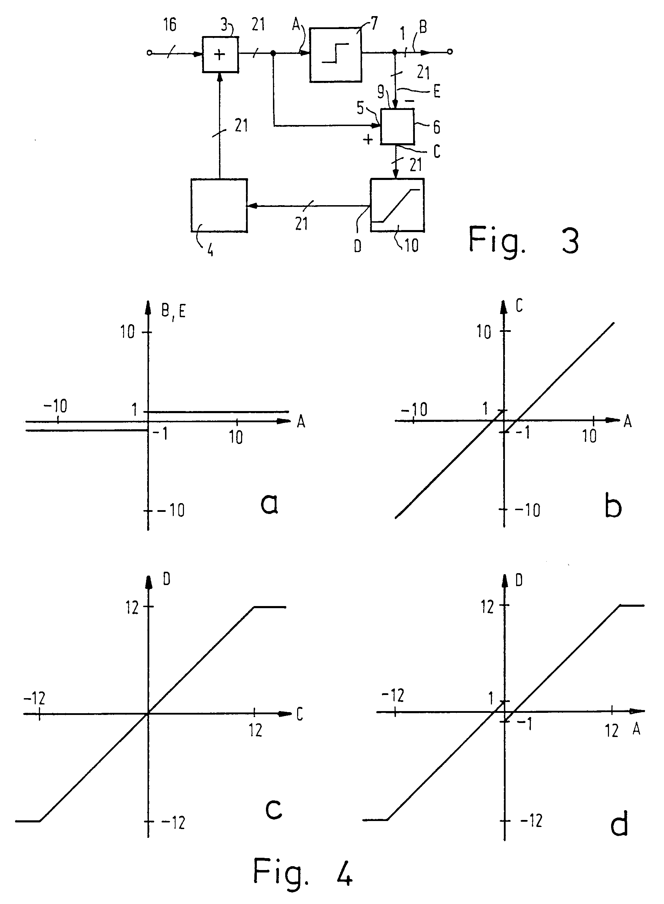

In Fig. 3 ist ein vereinfachtes Ausführungsbeispiel des Störgeräuschformers 2 dargestellt. Das Ausgangssignal des Interpolationsfilters 1, das 256-fach überabgetastet worden ist, wird mit einer Wortbreite von 16 Bit dem Ausgangssignal der Filteranordnung 4 mit einer Wortbreite von 21 Bit in der Überlagerungsstufe 3 überlagert. (Das niederwertigste Bit des Ausgangssignals der Filteranordnung 4 und das niederwertigste Bit des Ausgangssignals des Interpolationsfilters 1 haben die gleiche Wertigkeit.) Das Ausgangssignal A der Überlagerungsstufe 3 mit einer Wortbreite von 21 Bit wird einerseits dem Quantisierer 7 und andererseits dem Subtrahierer 6 zugeleitet. Der Quantisierer 7 gibt ein Ausgangssignal B mit zwei möglichen Werten ab. Das Ausgangssignal B nimmt einen ersten Zustand an, wenn das Ausgangssignal der Überlagerungsstufe 3 positiv ist, und einen zweiten Zustand, wenn das Ausgangssignal der Überlagerungsstufe negativ ist. Das Ausgangssignal B, das an den hier nicht dargestellten Digital-Analog-Umsetzer 8 weitergeleitet wird, hat eine Worbreite von 1 Bit, während das Ausgangssignal E des Quantisierers 7, welches dem Subtrahierer 6 zugeleitet wird, eine Wortbreite von 21 Bit aufweist. Die Übertragungscharakteristik des Quantisierers 7 ist in Fig. 4a dargestellt. Der maximale im Störgeräuschformer 2 auftretende Signalwert wird mit 16 festgelegt und der minimale Wert mit -16. Die Ausgangssignale B und E nehmen den Wert +1 bei einem positiven digitalen Signal A und den Wert -1 bei einem negativen digitalen Signal A an. Im Subtrahierer 6 wird das Ausgangssignal E des Quantisierers 7 vom Ausgangssignal A der Überlagerungsstufe 3 subtrahiert. Das Differenzsignal C am Ausgang des Subtrahierers 6 wird dem Begrenzer 10 zugeführt. Die Übertragungschrakteristik, die die Abhängigkeit des Differenzsignals C vom Ausgangssignal A der Überlagerungsstufe 3 darstellt, ist in Fig. 4b gezeigt. Die Übertragungscharakteristik des Begrenzers 10 ist in Fig. 4c dargestellt. Bei diesem Ausführungsbeispiel des Störgeräuschformers 2 liegt der obere bzw. untere Begrenzerschwellwert bei +12 bzw. -12. Die Übertragungscharakteristik, die das Ausgangssignal D des Begrenzers 10 in Abhängigkeit vom Ausgangssignal A der Überlagerungsstufe 3, zeigt Fig. 4d. Der Ausgang des Begrenzers 10 ist mit der Filteranordnung 4 verbunden.

Das Ausgangssignal B des Quantisierers 7 wird dem hier nicht näher dargestellten Digital-Analog-Umsetzer 8 zugeführt, der aus dem 1 Bit-Signal ein analoges Signal erzeugt, welches einem hier nicht näher dargestellten Integrator zugeleitet wird, der ein analoges Signal erzeugt, welches dem zeitlichen Mittelwert des Ausgangssignals des Digital-Analog-Umsetzers entspricht.

**Patentansprüche**

1. Digitale Schaltungsanordnung mit einem Interpolationsfilter (1) zum Überabtasten eines digitalen Eingangssignals, das als Folge amplitudendiskreter Abtastwerte mit einer bestimmten Abtastfrequenz vorliegt, mit einem Störgeräuschformer (2), der eine Überlagerungsstufe (3) enthält, deren Ausgang mit einem Quantisierer (7), deren erster Eingang mit dem Interpolationsfilter (1) und deren zweiter Eingang mit einer in einer Rückkopplungsschleife vorgesehenen Filteranordnung (4) zweiter Ordnung zum Filtern eines Quantisierungsfehlersignals des Quantisierers gekoppelt ist, und mit einem mit einem Ausgang des Quantisierers (7) gekoppelten Digital-Analog-Umsetzer (8), dadurch gekennzeichnet, daß ein Begrenzer (10) in die Rückkopplungsschleife geschaltet ist.

2. Digitale Schaltungsanordnung nach Anspruch 1,
dadurch gekennzeichnet, daß die Anordnung einen Subtrahierer (6) zum Erzeugen des Quantisierungsfehlersignals enthält, dessen erster Eingang mit dem Ausgang der Überlagerungsstufe (3), dessen zweiter Eingang mit dem Ausgang des Quantisierers (7) und dessen Ausgang mit einem Eingang des Begrenzers (10) gekoppelt ist, dessen Ausgang mit einem Eingang der Filteranordnung (4) gekoppelt ist, deren Ausgang mit dem zweiten Eingang der Überlagerungsstufe (3) gekoppelt ist.

3. Digitale Schaltungsanordnung nach Anspruch 2,
dadurch gekennzeichnet, daß die Filteranordnung (4) ein erstes Register (12) enthält, dessen Eingang mit dem Begrenzer (10) und dessen Ausgang mit einem Verstärker (13) und mit einem zweiten Register (14) gekoppelt ist und daß die Filteranordnung (4) einen weiteren Subtrahierer (16) enthält, dessen erster Eingang mit dem zweiten Register (14), dessen zweiter Eingang mit dem Verstärker (13) und dessen Ausgang mit dem Ausgang der Filteranordnung (4) gekoppelt ist.

4. Digitale Schaltungsanordnung nach einem der vorhergehenden Ansprüche,
dadurch gekennzeichnet, daß der Quantisierer (7) zum Erzeugen eines 1 Bit-Signals vorgesehen ist, das einen ersten Zustand annimmt, wenn das Ausgangssignal der Überlagerungsstufe (3) positiv ist, und daß einen zweiten Zustand annimmt, wenn das Ausgangssignal der Überlagerungsstufe (3) negativ ist.

## Claims

1. A digital circuit arrangement comprising an interpolation filter (1) for oversampling a digital input signal which appears as a sequence of discrete-amplitude samples with a specific sampling rate, a noise shaper (2) which includes an adder stage (3) having its output is coupled to a quantizer (7), having its first input coupled to the interpolation filter (1), and having its second input coupled to a second-order filter arrangement (4) provided in a feedback loop in order to filter a quantization-error signal of the quantizer, and a digital-to-analog converter (8) coupled to a output of the quantizer (7), characterized in that a limiter (10) is arranged in the feedback loop.

2. A digital circuit arrangement as claimed in Claim 1, characterized in that the arrangement comprises a subtracter (6) for generating the quantization-error signal, which subtracter has its first input coupled to the output of the adder stage (3), its second input coupled to the output of the quantizer (7), and its output coupled to an input of the limiter (10), whose output is coupled to a input of the filter arrangement (4), which has its output coupled to the second input of the adder stage (3).

3. A digital circuit arrangement as claimed in Claim 2, characterized in that the filter arrangement (4) includes a first register (12) whose input is coupled to the limiter (10) and whose output is coupled to an amplifier (13) and to a second register (14), and the filter arrangement (4) includes a further subtracter (16) whose first input is coupled to the second register (14), whose second input is coupled to the amplifier (13) and whose output is coupled to the output of the filter arrangement (4).

4. A digital circuit arrangement as claimed in any one of the preceding Claims, characterized in that the quantizer (7) is adapted to generate a 1-bit signal which assumes a first state if the output signal of the adder stage (3) is positive and which assumes a second state if the output signal of the adder stage (3) is negative.

## Revendications

1. Circuit numérique comportant un filtre d'interpolation (1) pour suréchantillonner un signal numérique d'entrée apparaissant comme séquence de valeurs d'échantillonnage à amplitude discrète à une fréquence d'échantillonnage déterminée, un conformateur de bruit parasite (2) pourvu d'un étage additionneur (3) dont la sortie est couplée à un quantificateur (7) ayant sa première entrée couplée au filtre d'interpolation (1) et sa seconde entrée couplée à un circuit filtre de deuxième ordre (4) prévu dans une boucle de réaction et servant à filtrer un signal d'erreur de quantification du quantificateur, et un convertisseur numérique-analogique couplé à une sortie du quantificateur (7), caractérisé en ce qu'un limiteur (10) est inclus dans la boucle de réaction.

2. Circuit numérique selon la revendication 1, caractérisé en ce qu'il comporte un soustracteur (6) pour engendrer le signal d'erreur de quantification soustracteur ayant sa première entrée couplée à la sortie de l'étage additionneur (3), sa seconde entrée couplée à la sortie du quantificateur (7) et sa sortie couplée a une entrée du limiteur (10) qui a sa sortie couplée à une entrée du circuit filtre (4) dont la sortie est couplée à la seconde entrée de l'étage additionneur (3).

3. Circuit numérique selon la revendication 2, caractérisé en ce que le circuit filtre (4) comporte un premier registre (12) ayant son entrée couplée au limiteur (10) et sa sortie couplée à un amplificateur (13) et à un second registre (14) et en ce que le circuit filtre (4) comporte un autre soustracteur (16) ayant sa première entrée couplée au second registre (14), sa seconde entrée couplée à l'amplificateur (13) et sa sortie couplée à la sortie du circuit filtre (4).

4. Circuit numérique selon l'une quelconque des revendications précédentes, caractérisé en ce que le quantificateur (7) engendre un signal à 1 bit qui prend un premier état lorsque le signal de sortie de l'étage additionneur (3) est positif et qui prend un second état lorsque le signal de sortie de l'étage additionneur (3) est négatif.

Fig. 1

Fig. 2

Fig. 3

Fig. 4